Europäisches Patentamt

European Patent Office

Office européen des brevets

(19)

(11) Publication number: 0 334 384
A1

## (12) EUROPEAN PATENT APPLICATION

(21) Application number: 89105324.1

(22) Date of filing: 24.03.89

(51) Int. Cl.4: **C23G 5/028** , **C11D 7/30** ,
//H05K3/26

(30) Priority: 25.03.88 JP 72404/88
15.04.88 JP 93670/88

(43) Date of publication of application:
27.09.89 Bulletin 89/39

(84) Designated Contracting States:
DE FR GB

(71) Applicant: **DAIKIN INDUSTRIES, LIMITED**
**Umeda Center Building 4-12 Nakazaki-nishi**
**2-chome Kita-ku**
**Osaka 530(JP)**

(72) Inventor: **Tamura, Kohji**
**4-26, Tadain-aza Koderamae**
**Kawanishi-shi Hyogo(JP)**
Inventor: **Omure, Yukio**
**4-15, Magami-cho 2-chome**
**Takatsuki-shi Osaka(JP)**
Inventor: **Ide, Satoshi**
**4-12-5, Kitaeguchi Higashiyodogawa-ku**
**Osaka-shi Osaka(JP)**
Inventor: **Hanatani, Naoyoshi**
**2-21-21, Hitotsuya**
**Settsu-shi Osaka(JP)**
Inventor: **Fukuzawa, Toshimasa**
**2-21-21, Hitotsuya**
**Settsu-shi Osaka(JP)**

(74) Representative: **Türk, Gille, Hrabal**
**Bruckner Strasse 20**
**D-4000 Düsseldorf 13(DE)**

(54) Incombustible azeotropic like solvent compositions.

(57) Incombustible azeotropic like solvent compositions comprising 1,1,2-trichloro-1,2,2-trifluoroethane, hydrocarbons and alcohols.

FIG. 1

## INCOMBUSTIBLE AZEOTROPIC LIKE SOLVENT COMPOSITIONS

The present invention relates to incombustible azeotropic like solvent compositions comprising 1,1,2-trichloro-1,2,2-trifluoroethane (hereinafter referred to as "Flon-113"), hydrocarbons and alcohols.

Hitherto, Flon-113 which is widely used as washing or cleaning liquids or solvents, because of their various advantages such as incombustibility, low toxity and selective solubility that they can dissolve fats, greases and the like without erosion of high molecular compounds such as rubbers and plastics.

Also, it is known that in order to increase solubility power against organic stains and polar stains, particularly against fluxes, lower alcohols such as methyl alcohol and ethyl alcohol are mixed with Flon-113.

Recently, with advance in electronic parts such as semiconductors, it is important to wash out and remove fluxes used in print circuit production or waxes which are used for temporary fixing in preparation steps of such electronic parts. For washing out the waxes and fluxes, trichloroethylene and 1,1,1-trichloroethane are generally used, but there are troubles that they pollute atomosphere and underground water because of their high toxity.

On the other hand, hydrocarbons are not suitable for use of cleaning because of their combustibility. Also, though there is known mixtures with Flon-113, the mixtures are not easy to handle due to their unstableness, because, for example, when they are used repeatedly in vapor washing method, the mixtures change in the proportion of components to be combustible even if the starting mixtures are incombustible.

There is also known an azeotropic composition of Flon-113 and ethyl alcohol and an azeotropic composition of Flon-113 and ethyl alcohol and nitromethane. These compositions, however, do not have a sufficient solubility power against fluxes and waxes.

According to the present invention, there can be provided azeotropic like solvent compositions which can dissolve waxes and fluxes more than Flon-113 and are stable in an incombustible range. The compositions of the present invention comprises a major amount of Flon-113, 2 to 15 % (% by weight, hereinafter the same) of hydrocarbons and 1 to 8 % of alcohols.

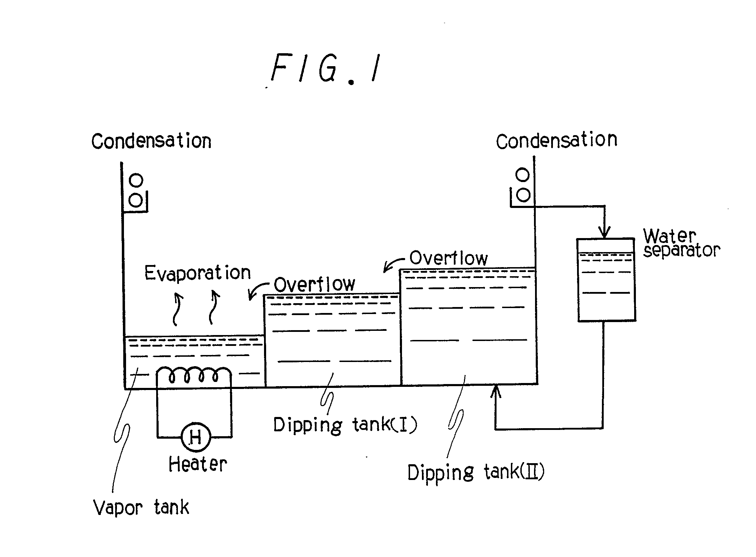

Fig. 1 is a diagramatic view of the three-tank-cleaning machine used in Example 7.

The most characteristic matter of the present invention is to provide incombustible compositions in spite of blending hydrocarbons, and to give an increased solubility power against waxes and fluxes.

An amount of Flon-113 is preferably 77 to 97 % on the composition base. An amount of the hydrocarbons is 2 to 15 % and an amount of the alcohols is 1 to 8 %. If a composition has a mixing ratio out of the above ranges, the composition intends to vary its mixing ratio in repeated use and becomes unstable.

As the hydrocarbons there is preferably used a hydrocarbon having a boiling point of 49° to 62°C, particularly a mixture having a boiling point within a range of 49° to 62°C prepared by mixing two or more hydrocarbons.

As the hydrocarbon mixture, there is preferably employed a mixture which contains, on the hydrocarbon mixture base, cyclopentane (b.p. 49°C) and 2-methylpentane (b.p. 60°C), particularly not less than 50 %, preferably 60 to 70 % of cyclopentane, and not less than 5 %, preferably 20 to 30 % of 2-methylpentane in view of minor change of composition. These hydrocarbons can be obtained, for example, as petroleum distilates, and may contain other remaining hydrocarbons such as 3-methylpentane, 2,2-dimethylbutane, 2,3-dimethylbutane, methylcyclopentane and n-hexane, up to 10 % on the hydrocarbon mixture base.

However, when a boiling point of the hydrocarbons is higher than 62°C, a proportion of the hydrocarbons in liquid state becomes greater so that the composition becomes combustible, and when lower than 49°C, a proportion of hydrocarbons in gaseous state becomes greater so that the composition becomes also combustible.

As the alcohols used in the present invention there is preferably employed an aliphatic alcohol having 1 to 4 carbon atoms which yields an azeotropic mixture with Flon-113. Examples of the alcohols are, for instance, methyl alcohol, ethyl alcohol, n-propyl alcohol, iso-propyl alcohol, tert-butyl alcohol, and a mixture thereof. Practically preferable mixing amounts (% by weight) with respect to each alcohol on the composition base are as follows:

| | Alcohol | | | | |
|---|---|---|---|---|---|
| | Methanol | Ethanol | iso-Propanol | n-Propanol | t-Butanol |
| Hydrocarbon | 5 to 10 | 8 to 13 | 10 to 15 | 10 to 15 | 10 to 15 |
| Alcohol | 5 to 8 | 3 to 5 | 2 to 4 | 1 to 3 | 1 to 3 |
| Flon-113 | 82 to 90 | 82 to 89 | 81 to 88 | 82 to 89 | 82 to 89 |

The solvent composition of the present invention having the above mixing ratio and boiling point range shows an azeotropic like state, i.e. less proportion change, and is incombustible.

Since the solvent composition is stable in incombustible state, the composition is not only used in safety and is easy to control the particular proportion of liquid and to recover and recycle the solvent composition. Therefore the solvent composition can be applied to a recycle cleaning stystem or a vapor cleaning system. The solvent composition has an increased solubility power to waxes due to the mixing of a small amount (2 to 15 %) of the hydrocarbons. Also according to the present invention, bad influences of the hydrocarbons, i.e. elosion of rubbers and plastics can be reduced, and thus articles to be cleaned can be washed whole. Also, the composition does not erode metals and does not degrade. In addition, there is an advantage that an amount of Flon-113 which is one of perhaloethanes that may destroy the ozone layer can be decreased.

Though the solvent composition of the present invention is chemically stable, stabilizers may be added to the composition.

It is preferred that the stabilizers can be distilled together with the composition, more desirably can form an azeotropic system, in addition that the stabilizers have a large stabilizing effect against the composition.

Examples of the stabilizers are, for instance, aliphatic nitro compounds such as nitromethane, nitroethane and nitropropane; acetylene alcobols such as 3-methyl-1-butyne-3-ol and 3-methyl-1-pentyne-3-ol; epoxides such as glycidol, methyl glycidyl ether, allyl glycidyl ether, phenyl glycidyl ether, 1,2-butylene oxide, cyclohexene oxide and epichlorohydrin; ethers such as dimethoxymethane, 1,2-dimethoxyethane, 1,4-dioxane and 1,3,5-trioxane; olefinic alcohols such as allyl alcohol, 1-butene-3-ol and 3-methyl-1-butene-3-ol; acrylates such as methyl acrylate, ethyl acrylate and butyl acrylate; and the like. These stabilizers can be used alone or in an admixture. In addition, other compounds may be used together with the above stabilizers. In such case synergic stabilizing effect can be obtained. Examples of the other compounds are, for instance, phenols such as phenol, trimethyl-phenol, cyclohexylphenol, thymol, 2,6-di-t-butyl-4-methylphenol, butylhydroxyanisole and isoeugenol; amines such as hexylamine, pentylamine, dipropylamine, diiso-propylamine, diisobutylamine, triethylamine, tributyl-amine, pyridine, N-methylmorpholine, cyclohexylamine, 2,2,6,6-tetramethylpyridine and N,N'-diallyl-p-phenylene-diamine; triazoles such as benzotriazole, 2-(2'-hydroxy-5'-methylphenyl)benzotriazole and chlorobenzotriazole; and the like.

Amount of the stabilizers varies on kinds of the stabilizers, and is generally 0.1 to 10 %, preferably 0.5 to 5 % on the composition base.

The composition of the present invention is useful for cleaning fluxes of print circuit, or for removing and cleaning fats, dusts and figureprints on various precision devises, glass parts, plastic parts or ceramic parts, and is useful as a cleaning solvent for temporary fixing waxes used in cutting or polishing steps of silicon wafers for semiconductors, quartz or ceramics, and also as a dehydating or drying agent for electroplated articles washed with water, as well as a solvent medium for pulverizing metals or for dispersing or kneading pulverized metals.

The present invention is more specifically described and explained by means of the following Examples. It is to be understood that the present invention is not limited to the Examples and various changes and modifications may be made in the invention without departing from the spirit and scope thereof.

### Example 1

Flon-113, the following hydrocarbon mixture (b.p. 54° to 57°C) and ethyl alcohol were admixed in a weight ratio of 85.9/10.0/4.1 to obtain the solvent composition (b.p. 44.4° to 45.0°C). This composition was incombustible.

EP 0 334 384 A1

| Hydrocarbon mixture | |
|---|---|
| (Components) | (% by weight) |
| Cyclopentane | 65 |
| 2-Methylpentane | 35 |

## Example 2

Flon-113, the following hydrocarbon mixture (b.p. 54° to 58°C) and ethyl alcohol were admixed in a weight ratio of 85.9/10.0/4.1 to obtain the solvent composition (b.p. 44.4° to 45.0°C). This composition was incombustible.

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

## Example 3

Flon-113, the following hydrocarbon mixture (b.p. 49° to 52°C) and ethyl alcohol were admixed in a weight ratio of 86.1/10.0/3.9 to obtain the solvent composition (b.p. 43.5° to 44.1°C). This composition was incombustible.

| Hydrocarbon mixture | |
|---|---|
| (Components) | (% by weight) |
| Cyclopentane | 89 |
| 2-Methylpentane | 10 |
| n-Hexane | 1 |

## Example 4

Flon-113, the following hydrocarbon mixture (b.p. 54° to 58°C) and ethyl alcohol were admixed in a weight ratio of 83.9/12.0/4.0 to obtain the solvent composition (b.p. 44.6° to 45.2°C). This composition was incombustible.

4

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

### Example 5

Flon-113, the following hydrocarbon mixture (b.p. 49° to 52°C), ethyl alcohol and nitromethane were admixed in a weight ratio of 86.7/9.0/3.8/0.5 to obtain the solvent composition (b.p. 43.4° to 43.9°C). This composition was incombustible.

| Hydrocarbon mixture | |
|---|---|
| (Components) | (% by weight) |
| Cyclopentane | 89 |
| 2-Methylpentane | 10 |
| n-Hexane | 1 |

### Example 6

Flon-113, the following hydrocarbon mixture (b.p. 54° to 58°C), ethyl alcohol and nitromethane were admixed in a weight ratio of 86.0/9.5/4.0/0.5 to obtain the solvent composition (b.p. 44.2° to 44.8°C). This composition was incombustible.

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

### Comparative Example 1

Flon-113 and the following hydrocarbon mixture (b.p. 49° to 52°C) were admixed in a weight ratio of 85/15 to obtain a comparative solvent composition. This composition was incombustible.

| Hydrocarbon mixture | |
|---|---|
| (Components) | (% by weight) |
| Cyclopentane | 88 |
| 2-Methylpentane | 10 |
| n-Hexane | 2 |

## Comparative Example 2

Flon-113 and the following hydrocarbon mixture (b.p. 54° to 58°C) were admixed in a weight ratio of 85/15 to obtain a comparative solvent composition. This composition was incombustible.

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

## Comparative Example 3

Flon-113 and the following hydrocarbon mixture (b.p. 59° to 62°C) were admixed in a weight ratio of 90/10 to obtain a comparative solvent composition. This composition was incombustible.

| Hydrocarbon mixture | |
|---|---|
| (Components) | (% by weight) |
| Cyclopentane | 4 |
| 2-Methylpentane | 67 |
| 2,3-Dimethylbutane | 7 |
| 3-Methylpentane | 20 |
| n-Hexane | 2 |

## Comparative Example 4

Flon-113 and the following hydrocarbon mixture (b.p. 54° to 58°C) were admixed in a weight ratio of 95/5 to obtain a comparative solvent composition. This composition was incombustible.

6

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

Comparative Example 5

Flon-113 and the following hydrocarbon mixture (b.p. 41° to 44° C) were admixed in a weight ratio of 90/10 to obtain a comparative solvent composition. This composition was incombustible.

| Hydrocarbon mixture | |
|---|---|
| (Components) | (% by weight) |
| Cyclopentane | 50 |
| n-Pentane | 50 |

Comparative Example 6

Flon-113 and ethyl alcohol were admixed in a weight ratio of 96.0/4.0 to obtain a comparative solvent composition. This composition was incombustible and had an azeotropic boiling point (44.7° C).

Comparative Example 7

Flon-113, ethyl alcohol and nitromethane were admixed in a weight ratio of 95.3/3.6/1.1 to obtain a comparative solvent composition. This composition was incombustible and had an azeotropic boiling point (44.4° C).

Example 7

The change in a proportion of the components of the solvent compositions prepared in Examples 1 to 6 and Comparative Examples 1 to 5 was measured by the following method. The results are shown in Tables 1 to 11.

The method is carried out by using a three-tank-cleaning machine shown in Fig. 1 according to the cleaning cycle:

7

```
                Evaporate
Vapor  tank ─────────────> Water separator ──────────────
                Condense

          Overflow
─────> Dipping  tank(II) ─────────> Dipping  tank(I) ────

Overflow
─────────────> Vapor  tank.
```

The solvent composition to be tested is cycled for 3 days (8 hours per day). The proportions of the components in the vapor tank and the dipping tank(II) are measured, respectively. The measurement is conducted 8 hours after (1 day after), 16 hours after (2 days after) and 24 hours after (3 days after).

Table 1

| (Example 1) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 85.9 | 85.9 | 86.0 | 86.1 |
| | Hydrocarbon mixture | | 10.0 | 10.0 | 9.9 | 9.8 |
| | Ethyl alcohol | | 4.1 | 4.1 | 4.1 | 4.1 |
| | Hydrocarbon | Cyclopentane | 6.5 | 6.4 | 6.3 | 6.3 |
| | | 2-Methylpentane | 3.5 | 3.6 | 3.6 | 3.5 |
| | | 2,3-Dimethylbutane | - | - | - | - |
| | | 3-Methylpentane | - | - | - | - |
| | | 2,2-dimethylbutane | - | - | - | - |
| | | n-Hexane | - | - | - | - |
| | Combustibility | | None | None | None | None |
| Dipping tank (II) | Flon-113 | | 85.9 | 85.9 | 85.8 | 85.8 |
| | Hydrocarbon mixture | | 10.0 | 10.0 | 10.1 | 10.1 |
| | Ethyl alcohol | | 4.1 | 4.1 | 4.1 | 4.1 |
| | Hydrocarbon | Cyclopentane | 6.5 | 6.6 | 6.7 | 6.7 |
| | | 2-Methylpentane | 3.5 | 3.4 | 3.4 | 3.4 |
| | | 2,3-Dimethylbutane | - | - | - | - |
| | | 3-Methylpentane | - | - | - | - |
| | | 2,2-Dimethylbutane | - | - | - | - |
| | | n-Hexane | - | - | - | - |
| | Combustibility | | None | None | None | None |

Table 2

| (Example 2) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 85.9 | 85.9 | 86.0 | 86.1 |
| | Hydrocarbon mixture | | 10.0 | 10.0 | 9.9 | 9.8 |
| | Ethyl alcohol | | 4.1 | 4.1 | 4.1 | 4.1 |
| | Hydrocarbon | Cyclopentane | 6.5 | 6.4 | 6.3 | 6.3 |
| | | 2-Methylpentane | 2.4 | 2.5 | 2.5 | 2.4 |
| | | 2,3-Dimethylbutane | 0.5 | 0.5 | 0.5 | 0.5 |
| | | 3-Methylpentane | 0.5 | 0.5 | 0.5 | 0.5 |
| | | 2,2-dimethylbutane | 0.1 | 0.1 | 0.1 | 0.1 |
| | | n-Hexane | - | - | - | - |
| | Combustibility | | None | None | None | None |
| Dipping tank (II) | Flon-113 | | 85.9 | 85.9 | 85.8 | 85.8 |
| | Hydrocarbon mixture | | 10.0 | 10.0 | 10.1 | 10.1 |
| | Ethyl alcohol | | 4.1 | 4.1 | 4.1 | 4.1 |
| | Hydrocarbon | Cyclopentane | 6.5 | 6.6 | 6.7 | 6.8 |
| | | 2-Methylpentane | 2.4 | 2.3 | 2.3 | 2.3 |
| | | 2,3-Dimethylbutane | 0.5 | 0.5 | 0.5 | 0.5 |
| | | 3-Methylpentane | 0.5 | 0.5 | 0.5 | 0.4 |
| | | 2,2-Dimethylbutane | 0.1 | 0.1 | 0.1 | 0.1 |
| | | n-Hexane | - | - | - | - |
| | Combustibility | | None | None | None | None |

Table 3

| (Example 3) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 86.1 | 87.9 | 88.4 | 88.5 |
| | Hydrocarbon mixture | | 10.0 | 8.2 | 7.7 | 7.6 |
| | Ethyl alcohol | | 3.9 | 3.9 | 3.9 | 3.9 |
| | Hydrocarbon | Cyclopentane | 8.9 | 7.0 | 6.5 | 6.4 |
| | | 2-Methylpentane | 1.0 | 1.0 | 1.0 | 1.0 |
| | | 2,3-Dimethylbutane | - | - | - | - |
| | | 3-Methylpentane | - | - | - | - |
| | | 2,2-dimethylbutane | - | - | - | - |
| | | n-Hexane | 0.1 | 0.2 | 0.2 | 0.2 |
| | Combustibility | | None | None | None | None |
| Dipping tank (II) | Flon-113 | | 86.1 | 85.2 | 85.0 | 84.9 |
| | Hydrocarbon mixture | | 10.0 | 10.9 | 11.1 | 11.2 |
| | Ethyl alcohol | | 3.9 | 3.9 | 3.9 | 3.9 |
| | Hydrocarbon | Cyclopentane | 8.9 | 9.8 | 10.0 | 10.1 |
| | | 2-Methylpentane | 1.1 | 1.1 | 1.1 | 1.1 |
| | | 2,3-Dimethylbutane | - | - | - | - |
| | | 3-Methylpentane | - | - | - | - |
| | | 2,2-Dimethylbutane | - | - | - | - |
| | | n-Hexane | 0.1 | - | - | - |
| | Combustibility | | None | None | None | None |

Table 4

| (Example 4) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 83.9 | 84.7 | 84.9 | 85.2 |
| | Hydrocarbon mixture | | 12.0 | 11.4 | 11.2 | 11.0 |
| | Ethyl alcohol | | 4.0 | 3.9 | 3.9 | 3.8 |
| | Hydrocarbon | Cyclopentane | 7.8 | 6.8 | 6.5 | 6.0 |
| | | 2-Methylpentane | 2.9 | 3.2 | 3.3 | 3.4 |
| | | 2,3-Dimethylbutane | 0.6 | 0.6 | 0.6 | 0.7 |
| | | 3-Methylpentane | 0.6 | 0.7 | 0.7 | 0.8 |
| | | 2,2-dimethylbutane | 0.1 | 0.1 | 0.1 | 0.1 |
| | | n-Hexane | - | - | - | - |
| | Combustibility | | None | None | None | None |
| Dipping tank (II) | Flon-113 | | 83.9 | 83.6 | 83.4 | 83.3 |
| | Hydrocarbon mixture | | 12.0 | 12.4 | 12.5 | 12.6 |
| | Ethyl alcohol | | 4.0 | 4.0 | 4.1 | 4.1 |
| | Hydrocarbon | Cyclopentane | 7.8 | 8.4 | 8.5 | 8.8 |
| | | 2-Methylpentane | 2.9 | 2.8 | 2.8 | 2.7 |
| | | 2,3-Dimethylbutane | 0.6 | 0.6 | 0.6 | 0.6 |
| | | 3-Methylpentane | 0.6 | 0.5 | 0.5 | 0.4 |
| | | 2,2-Dimethylbutane | 0.1 | 0.1 | 0.1 | 0.1 |
| | | n-Hexane | - | - | - | - |
| | Combustibility | | None | None | None | None |

Table 5

| (Example 5) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 86.7 | 88.4 | 88.9 | 89.0 |
| | Hydrocarbon mixture | | 9.0 | 7.4 | 6.9 | 6.8 |
| | Ethyl alcohol | | 3.8 | 3.8 | 3.8 | 3.8 |
| | Nitromethane | | 0.5 | 0.4 | 0.4 | 0.4 |
| | Hydrocarbon | Cyclopentane | 8.0 | 6.3 | 5.8 | 5.7 |
| | | 2-Methylpentane | 0.9 | 0.9 | 0.9 | 0.9 |
| | | 2,3-Dimethylbutane | - | - | - | - |
| | | 3-Methylpentane | - | - | - | - |
| | | 2,2-dimethylbutane | - | - | - | - |
| | | n-Hexane | 0.1 | 0.2 | 0.2 | 0.2 |
| | Combustibility | | None | None | None | None |
| Dipping tank (II) | Flon-113 | | 86.7 | 85.8 | 85.6 | 85.5 |
| | Hydrocarbon mixture | | 9.0 | 9.9 | 10.1 | 10.2 |
| | Ethyl alcohol | | 3.8 | 3.8 | 3.8 | 3.8 |
| | Nitromethane | | 0.5 | 0.5 | 0.5 | 0.5 |
| | Hydrocarbon | Cyclopentane | 8.0 | 8.9 | 9.1 | 9.2 |
| | | 2-Methylpentane | 0.9 | 1.0 | 1.0 | 1.0 |
| | | 2,3-Dimethylbutane | - | - | - | - |
| | | 3-Methylpentane | - | - | - | - |
| | | 2,2-Dimethylbutane | - | - | - | - |
| | | n-Hexane | 0.1 | - | - | - |
| | Combustibility | | None | None | None | None |

Table 6

| (Example 6) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 86.0 | 86.3 | 86.3 | 86.3 |
| | Hydrocarbon mixture | | 9.5 | 9.3 | 9.3 | 9.3 |
| | Ethyl alcohol | | 4.0 | 4.0 | 4.0 | 4.0 |
| | Nitromethane | | 0.5 | 0.4 | 0.4 | 0.4 |
| | Hydrocarbon | Cyclopentane | 6.1 | 5.9 | 5.9 | 5.9 |
| | | 2-Methylpentane | 2.3 | 2.3 | 2.3 | 2.3 |
| | | 2,3-Dimethylbutane | 0.5 | 0.5 | 0.5 | 0.5 |
| | | 3-Methylpentane | 0.5 | 0.5 | 0.5 | 0.5 |
| | | 2,2-dimethylbutane | 0.1 | 0.1 | 0.1 | 0.1 |
| | | n-Hexane | - | - | - | - |
| | Combustibility | | None | None | None | None |
| Dipping tank (II) | Flon-113 | | 86.0 | 86.0 | 86.0 | 86.0 |
| | Hydrocarbon mixture | | 9.5 | 9.5 | 9.5 | 9.5 |
| | Ethyl alcohol | | 4.0 | 4.0 | 4.0 | 4.0 |
| | Nitromethane | | 0.5 | 0.5 | 0.5 | 0.5 |
| | Hydrocarbon | Cyclopentane | 6.1 | 6.1 | 6.1 | 6.1 |
| | | 2-Methylpentane | 2.3 | 2.3 | 2.3 | 2.3 |
| | | 2,3-Dimethylbutane | 0.5 | 0.5 | 0.5 | 0.5 |
| | | 3-Methylpentane | 0.5 | 0.5 | 0.5 | 0.5 |
| | | 2,2-Dimethylbutane | 0.1 | 0.1 | 0.1 | 0.1 |
| | | n-Hexane | - | - | - | - |
| | Combustibility | | None | None | None | None |

Table 7

| (Comparative Example 1) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 85.0 | 88.2 | 89.7 | 89.8 |
| | Hydrocarbon mixture | | 15.0 | 11.2 | 10.3 | 10.2 |
| | Hydrocarbon | Cyclopentane | 13.3 | 8.9 | 7.8 | 7.7 |
| | | 2-Methylpentane | 1.5 | 1.8 | 2.0 | 2.0 |
| | | 2,3-Dimethylbutane | - | - | - | - |
| | | 3-Methylpentane | - | - | - | - |
| | | 2,2-dimethylbutane | - | - | - | - |
| | | n-Hexane | 0.2 | 0.5 | 0.5 | 0.5 |
| | Combustibility | | None | None | None | None |
| Dipping tank (II) | Flon-113 | | 85.0 | 83.2 | 82.8 | 82.7 |
| | Hydrocarbon mixture | | 15.0 | 16.8 | 17.2 | 17.3 |
| | Hydrocarbon | Cyclopentane | 13.3 | 15.5 | 16.0 | 16.1 |
| | | 2-Methylpentane | 1.5 | 1.3 | 1.2 | 1.2 |
| | | 2,3-Dimethylbutane | - | - | - | - |
| | | 3-Methylpentane | - | - | - | - |
| | | 2,2-Dimethylbutane | - | - | - | - |
| | | n-Hexane | 0.2 | - | - | - |
| | Combustibility | | None | Combustible | Combustible | Combustible |

Table 8

| (Comparative Example 2) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 85.0 | 85.7 | 86.7 | 88.1 |
| | Hydrocarbon mixture | | 15.0 | 14.3 | 13.3 | 11.9 |
| | Hydrocarbon | Cyclopentane | 9.8 | 7.1 | 5.6 | 4.0 |
| | | 2-Methylpentane | 3.6 | 4.9 | 4.9 | 5.0 |
| | | 2,3-Dimethylbutane | 0.7 | 1.1 | 1.3 | 1.4 |
| | | 3-Methylpentane | 0.7 | 1.1 | 1.4 | 1.4 |
| | | 2,2-dimethylbutane | 0.2 | 0.1 | 0.1 | 0.1 |
| | | n-Hexane | - | - | - | - |
| | Combustibility | | None | None | None | None |
| Dipping tank (II) | Flon-113 | | 85.0 | 83.9 | 83.4 | 83.2 |
| | Hydrocarbon mixture | | 15.0 | 16.1 | 16.6 | 16.8 |
| | Hydrocarbon | Cyclopentane | 9.8 | 11.7 | 12.8 | 13.4 |
| | | 2-Methylpentane | 3.6 | 3.0 | 2.6 | 2.5 |
| | | 2,3-Dimethylbutane | 0.7 | 0.6 | 0.5 | 0.4 |
| | | 3-Methylpentane | 0.7 | 0.6 | 0.5 | 0.3 |
| | | 2,2-Dimethylbutane | 0.2 | 0.2 | 0.2 | 0.2 |
| | | n-Hexane | - | - | - | - |
| | Combustibility | | None | Combustible | Combustible | Combustible |

Table 9

| (Comparative Example 3) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 90.0 | 81.8 | 80.0 | 78.9 |
| | Hydrocarbon mixture | | 10.0 | 18.2 | 20.0 | 21.1 |
| | Hydrocarbon | Cyclopentane | 0.5 | 0.1 | 0.1 | 0.1 |
| | | 2-Methylpentane | 6.7 | 13.1 | 14.1 | 15.1 |
| | | 2,3-Dimethylbutane | 0.7 | 1.3 | 1.5 | 1.6 |
| | | 3-Methylpentane | 2.0 | 3.5 | 4.0 | 4.1 |
| | | 2,2-dimethylbutane | - | - | - | - |
| | | n-Hexane | 0.1 | 0.3 | 0.3 | 0.3 |
| | Combustibility | | None | Combustible | Combustible | Combustible |
| Dipping tank (II) | Flon-113 | | 90.0 | 93.7 | 94.7 | 95.0 |
| | Hydrocarbon mixture | | 10.0 | 6.3 | 5.3 | 5.0 |
| | Hydrocarbon | Cyclopentane | 0.5 | 0.9 | 1.0 | 1.0 |
| | | 2-Methylpentane | 6.7 | 3.7 | 3.0 | 2.8 |
| | | 2,3-Dimethylbutane | 0.7 | 0.4 | 0.3 | 0.3 |
| | | 3-Methylpentane | 2.0 | 1.3 | 1.0 | 0.9 |
| | | 2,2-Dimethylbutane | - | - | - | - |
| | | n-Hexane | 0.1 | - | - | - |
| | Combustibility | | None | None | None | None |

Table 10

| (Comparative Example 4) | | | | | | |
|---|---|---|---|---|---|---|
| Tank | Components | | Proportion of the components (% by weight) | | | |
| | | | Intial | 1 day after | 2 days after | 3 days after |
| Vapor tank | Flon-113 | | 95.0 | 96.3 | 96.1 | 96.2 |
| | Hydrocarbon mixture | | 5.0 | 3.7 | 3.9 | 3.8 |
| | Hydrocarbon | Cyclopentane | 3.1 | 1.2 | 1.1 | 1.0 |
| | | 2-Methylpentane | 1.2 | 1.5 | 1.6 | 1.6 |
| | | 2,3-Dimethylbutane | 0.3 | 0.5 | 0.6 | 0.6 |
| | | 3-Methylpentane | 0.3 | 0.5 | 0.6 | 0.6 |
| | | 2,2-dimethylbutane | 0.1 | - | - | - |
| | | n-Hexane | - | - | - | - |
| | Combustibility | | None | None | None | None |
| Dipping tank (II) | Flon-113 | | 95.0 | 94.1 | 93.7 | 93.5 |
| | Hydrocarbon mixture | | 5.0 | 5.9 | 6.3 | 6.5 |
| | Hydrocarbon | Cyclopentane | 3.1 | 4.5 | 5.0 | 5.2 |
| | | 2-Methylpentane | 1.2 | 1.0 | 0.9 | 0.9 |
| | | 2,3-Dimethylbutane | 0.3 | 0.1 | 0.1 | 0.1 |
| | | 3-Methylpentane | 0.3 | 0.1 | 0.1 | 0.1 |
| | | 2,2-Dimethylbutane | 0.1 | 0.2 | 0.2 | 0.2 |
| | | n-Hexane | - | - | - | - |
| | Combustibility | | None | None | None | None |

Table 11

| (Comparative Example 5) | | | | | |
|---|---|---|---|---|---|
| Tank | Components | Proportion of the components (% by weight) | | | |
| | | Intial | 1 day after | 2 days after | 3 days after |
| Vapor tank | Flon-113 | 90.0 | 96.5 | 97.5 | 97.8 |
| | Hydrocarbon mixture | 10.0 | 3.5 | 2.4 | 2.2 |
| | Cyclopentane | 5.0 | 3.0 | 2.0 | 1.8 |
| | n-Pentane | 5.0 | 0.5 | 0.4 | 0.4 |
| | Combustibility | None | None | None | None |
| Dipping tank (II) | Flon-113 | 90.0 | 86.6 | 86.0 | 85.9 |
| | Hydrocarbon mixture | 10.0 | 13.4 | 14.0 | 14.1 |
| | Cyclopentane | 5.0 | 6.0 | 6.5 | 6.6 |
| | n-Pentane | 5.0 | 7.4 | 7.5 | 7.5 |
| | Combustibility | None | Combustible | Combustible | Combustible |

17

## Example 8

Flon-113, the following hydrocarbon mixture (b.p. 59° to 62°C) and methyl alcohol were admixed in a weight ratio of 90/4.0/6.0 to obtain the solvent composition (b.p. 40.3° to 41.0°C). This composition was incombustible.

| Hydrocarbon mixture | |
|---|---|
| (Components) | (% by weight) |
| Cyclopentane | 4 |
| 2-Methylpentane | 67 |
| 2,3-Dimethylbutane | 7 |
| 3-Methylpentane | 20 |
| n-Hexane | 2 |

## Example 9

Flon-113, the following hydrocarbon mixture (b.p. 54° to 58°C) and ethyl alcohol were admixed in a weight ratio of 86.0/10.0/4.0 to obtain the solvent composition (b.p. 44.3° to 44.8°C). This composition was incombustible.

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

## Example 10

Flon-113, the following hydrocarbon mixture (b.p. 49° to 52°C) and iso-propyl alcohol were admixed in a weight ratio of 86.0/11.0/3.0 to obtain the solvent composition (b.p. 45.8° to 46.3°C). This composition was incombustible.

| Hydrocarbon mixture | |
|---|---|
| (Components) | (% by weight) |
| Cyclopentane | 89 |
| 2-Methylpentane | 10 |
| n-Hexane | 1 |

18

## Example 11

Flon-113, the following hydrocarbon mixture (b.p. 54° to 58°C) and n-propyl alcohol were admixed in a weight ratio of 88.0/10.0/2.0 to obtain the solvent composition (b.p. 47.0° to 47.6°C). This composition was incombustible.

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

## Example 12

Flon-113, the following hydrocarbon mixture (b.p. 54° to 58°C) and tert-butyl alcohol were admixed in a weight ratio of 88.0/10.0/2.0 to obtain the solvent composition (b.p. 46.7° to 47.4°C). This composition was incombustible.

| Hydrocarbon mixture | |
|---|---|
| (Components) | (% by weight) |
| Cyclopentane | 65 |
| 2-Mehylpentane | 24 |
| 2,3-Dimethylbutane | 5 |
| 3-Methylpentane | 5 |
| 2,2-Dimethylbutane | 1 |

## Example 13

Flon-113, the following hydrocarbon mixture (b.p. 54° to 58°C), ethyl alcohol and iso-propyl alcohol were admixed in a weight ratio of 85.0/10.0/3.0/2.0 to obtain the solvent composition (b.p. 44.9° to 45.4°C). This composition was incombustible.

| Hydrocarbon mixture | |
|---|---|
| (Components) | (% by weight) |
| Cyclopentane | 65 |
| 2-Methylpentane | 24 |
| 2,3-Dimethylbutane | 5 |
| 3-Methylpentane | 5 |
| 2,2-Dimethylbutane | 1 |

## Example 14

The same evaporation-condensation cycle as in Example 7 was repeated with respect to the solvent compositions of Examples 8 to 13. The results are shown in Tables 12 to 17.

Table 12

| (Example 8) | | | | | |
|---|---|---|---|---|---|
| Tank | Components | Proportion of the components (% by weight) | | | |
| | | Intial | 1 day after | 2 days after | 3 days after |
| Vapor tank | Flon-113 | 90.0 | 89.8 | 89.9 | 90.0 |
| | Hydrocarbon mixture | 4.0 | 4.4 | 4.5 | 4.5 |
| | Methyl alcohol | 6.0 | 5.8 | 5.6 | 5.5 |
| | Combustibility | None | None | None | None |
| Dipping tank (II) | Flon-113 | 90.0 | 90.1 | 90.1 | 90.1 |
| | Hydrocarbon mixture | 4.0 | 3.8 | 3.7 | 3.7 |
| | Methyl alcohol | 6.0 | 6.1 | 6.2 | 6.2 |
| | Combustibility | None | None | None | None |

Table 13

| (Example 9) | | | | | |
|---|---|---|---|---|---|
| Tank | Components | Proportion of the components (% by weight) | | | |
| | | Intial | 1 day after | 2 days after | 3 days after |
| Vapor tank | Flon-113 | 86.0 | 86.1 | 86.3 | 86.3 |
| | Hydrocarbon mixture | 10.0 | 10.0 | 9.9 | 9.9 |
| | Ethyl alcohol | 4.0 | 3.9 | 3.8 | 3.8 |
| | Combustibility | None | None | None | None |
| Dipping tank (II) | Flon-113 | 86.0 | 85.9 | 85.8 | 85.8 |
| | Hydrocarbon mixture | 10.0 | 10.0 | 10.1 | 10.1 |
| | Ethyl alcohol | 4.0 | 4.1 | 4.1 | 4.1 |
| | Combustibility | None | None | None | None |

Table 14

| (Example 10) | | | | | |
|---|---|---|---|---|---|
| Tank | Components | Proportion of the components (% by weight) | | | |
| | | Intial | 1 day after | 2 days after | 3 days after |
| Vapor tank | Flon-113 | 86.0 | 86.6 | 86.8 | 86.8 |
| | Hydrocarbon mixture | 11.0 | 10.6 | 10.5 | 10.5 |
| | iso-Propyl alcohol | 3.0 | 2.8 | 2.7 | 2.7 |
| | Combustibility | None | None | None | None |
| Dipping tank (II) | Flon-113 | 86.0 | 85.7 | 85.6 | 85.6 |
| | Hydrocarbon mixture | 11.0 | 11.2 | 11.2 | 11.2 |
| | iso-Propyl alcohol | 3.0 | 3.1 | 3.2 | 3.3 |
| | Combustibility | None | None | None | None |

Table 15

| (Example 11) | | | | | |
|---|---|---|---|---|---|
| Tank | Components | Proportion of the components (% by weight) | | | |
| | | Intial | 1 day after | 2 days after | 3 days after |
| Vapor tank | Flon-113 | 88.0 | 87.6 | 87.6 | 87.6 |
| | Hydrocarbon mixture | 10.0 | 10.0 | 9.9 | 9.9 |
| | n-Propyl alcohol | 2.0 | 2.4 | 2.5 | 2.5 |
| | Combustibility | None | None | None | None |
| Dipping tank (II) | Flon-113 | 88.0 | 88.1 | 88.2 | 88.1 |
| | Hydrocarbon mixture | 10.0 | 10.1 | 10.1 | 10.1 |
| | n-Propyl alcohol | 2.0 | 1.8 | 1.7 | 1.8 |
| | Combustibility | None | None | None | None |

## EP 0 334 384 A1

Table 16

| (Example 12) | | | | | | |
|---|---|---|---|---|---|---|
| Tank | Components | Proportion of the components (% by weight) | | | | |
| | | Intial | 1 day after | 2 days after | 3 days after | |
| Vapor tank | Flon-113 | 88.0 | 88.2 | 88.4 | 88.3 | |
| | Hydrocarbon mixture | 10.0 | 10.0 | 9.9 | 10.0 | |
| | tert-Butyl alcohol | 2.0 | 1.8 | 1.7 | 1.7 | |
| | Combustibility | None | None | None | None | |
| Dipping tank (II) | Flon-113 | 88.0 | 87.9 | 87.7 | 87.7 | |
| | Hydrocarbon mixture | 10.0 | 10.0 | 10.1 | 10.1 | |
| | tert-Butyl alcohol | 2.0 | 2.1 | 2.2 | 2.2 | |
| | Combustibility | None | None | None | None | |

Table 17

| (Example 13) | | | | | |
|---|---|---|---|---|---|
| Tank | Components | Proportion of the components (% by weight) | | | |
| | | Intial | 1 day after | 2 days after | 3 days after |
| Vapor tank | Flon-113 | 85.0 | 83.9 | 83.6 | 83.5 |
| | Hydrocarbon mixture | 10.0 | 10.0 | 9.9 | 9.9 |
| | Ethyl alcohol | 3.0 | 3.1 | 3.2 | 3.2 |
| | iso-Propyl alcohol | 2.0 | 3.0 | 3.3 | 3.4 |
| | Combustibility | None | None | None | None |
| Dipping tank (II) | Flon-113 | 85.0 | 85.5 | 85.6 | 85.6 |
| | Hydrocarbon mixture | 10.0 | 10.0 | 10.1 | 10.1 |
| | Ethyl alcohol | 3.0 | 2.9 | 2.9 | 2.9 |
| | iso-Propyl alcohol | 2.0 | 1.6 | 1.4 | 1.4 |
| | Combustibility | None | None | None | None |

Example 15

With respect to the solvent compositions shown in Table 18, a solubility power to a flux were measured according to the following method.

To a substrate of a phenol resin for printed circuit (50 mm x 50 mm) a preflux (A-101B) and a postflux (MH-820V) which are available from Kabushiki Kaisha Tamura Seisakusho were applied in the order, and then baked at about 250°C for 3 minutes in an electric oven. After taking out the baked substrate from the oven and cooling it to room temperature, the cooled substrate was dipped into 300 ml of the solvent composition for 2 minutes. Condition of removal of the fluxes was observed with naked eyes. The results are shown in Table 18.

22

Table 18

| Solvent composition | Removal of fluxes |
|---|---|
| Example 8 | Completely removed |
| Example 9 | Completely removed |
| Example 10 | Completely removed |
| Example 11 | Completely removed |
| Example 12 | Completely removed |
| Example 13 | Completely removed |
| Comparative | |
| Methyl alcohol | Completely removed |
| Ethyl alcohol | Completely removed |
| iso-propyl alcohol | Completely removed |
| Flon-113 | Not removed |

## Example 16

Solubilities of processing waxes used for temporary fixing in preparation of silicon wafers were measured according to the following method.

A beaker of 200 cc was charged with 100 g of the solvent shown in Table 19. To the solvent of 35° C was dividedly added the powdered processing waxes shown in Table 19 (available from Nikka Seiko Co., Ltd.), and a solubility was evaluated.

The results are shown in Table 19.

The evaluation of the solubility is as follows:

◎: Soluble at a wax concentration of 2 % or more

○: Soluble at a wax concentration of 1 to 2 %

Δ: Partially soluble

×: Insoluble

## Exampel 17

With respect to the solvents shown in Table 19, influences (swelling) to various substrates (plastics) were measured according to the following method.

A glass autoclave of 100 cc was charged with 100 g of the solvent shown in Table 19 and a plastic test piece (5 X 50 X 2 mm). After allowing to stand in a thermostatic bath (50° C) for 4 hours, the change of weight and volume of the test piece were rapidly measured. The results are shown in Table 19.

Evaluation in Table 19 is as follows:

◎: Increased weight or volume being 0 to 1 %

○: Increased weight or volume being 1 to 3 %

Δ: Increased weight or volume being 3 to 5 %

×: Increased weight or volume being 5 % or more.

23

## Table 19

| Solvent | Solubility of Waxes | | | | Influences to Substrates | | | |
|---|---|---|---|---|---|---|---|---|
| | Protect | Electron | Flat low | Proof | Vinyl-chloride resin | ABS resin | Poly-propylene | Acrylic resin |
| Ex. 1 | ⊙ | ⊙ | ⊙ | ⊙ | ⊙ | ⊙ | ○ | ⊙ |
| Ex. 2 | ⊙ | ⊙ | ⊙ | ⊙ | ⊙ | ⊙ | ○ | ⊙ |
| Ex. 3 | ⊙ | ⊙ | ⊙ | ⊙ | ⊙ | ⊙ | ○ | ⊙ |
| Ex. 4 | ⊙ | ⊙ | ⊙ | ⊙ | ⊙ | ⊙ | ○ | ⊙ |
| Ex. 5 | ⊙ | ⊙ | ⊙ | ⊙ | ⊙ | ⊙ | ○ | ⊙ |
| Ex. 6 | ⊙ | ⊙ | ⊙ | ⊙ | ⊙ | ⊙ | ○ | ⊙ |
| Flon-113 | × | × | × | × | ⊙ | ⊙ | ⊙ | ⊙ |
| Hydrocarbons in Ex. 1 | ⊙ | ⊙ | ⊙ | ⊙ | ○ | △ | △ | △ |
| Hydrocarbons in Ex. 2 | ⊙ | ⊙ | ⊙ | ⊙ | ○ | △ | △ | △ |
| Hydrocarbons in Ex. 3 | ⊙ | ⊙ | ⊙ | ⊙ | ○ | △ | △ | △ |

- continued -

| Solvent | Solubility of Waxes | | | | Influences to Substrates | | | |
|---|---|---|---|---|---|---|---|---|
| | Protect | Electron | Flat low | Proof | Vinyl-chloride resin | ABS resin | Poly-propylene | Acrylic resin |
| Hydrocarbons in Ex. 4 | ◉ | ◉ | ◉ | ◉ | ○ | △ | △ | △ |
| Hydrocarbons in Ex. 5 | ◉ | ◉ | ◉ | ◉ | ○ | △ | △ | △ |
| Hydrocarbons in Ex. 6 | ◉ | ◉ | ◉ | ◉ | ○ | △ | △ | △ |
| Comp. Ex. 6 | ✕ | ✕ | △ | △ | ◉ | ◉ | ○ | ◉ |
| Comp. Ex. 7 | ✕ | ✕ | △ | △ | ◉ | ◉ | ○ | ◉ |
| Ethyl alcohol | ✕ | ✕ | △ | △ | ◉ | ◉ | ◉ | ◉ |
| Nitromethane | ○ | ○ | ○ | ○ | △ | △ | △ | ✕ |

## Example 18

Solubilities of processing waxes used for temporary fixing in preparation of silicon wafers were measured according to the following method.

A beaker of 200 cc was charged with 100 g of the solvent shown in Table 20. To the solvent was dividedly added four kinds of powdered paraffin waxes (m.p. $52°$ to $65°$ C, available from Nippon Seiro Co., Ltd.), and a solubility was evaluated.

The results are shown in Table 20.

The evaluation of the solubility is as follows:

⊚: Soluble at a wax concentration of 2 % or more

○: Soluble at a wax concentration of 1 to 2 %

△:Soluble at a wax concentration of up to 1 %

×: Insoluble

## Exampel 19

With respect to the solvents shown in Table 20, influences (swelling) to various substrates (plastics) were measured according to the following method.

A glass autoclave of 100 cc was charged with 100 g of the solvent shown in Table 20 and a plastic test piece (5 X 50 X 2 mm). After allowing to stand in a thermostatic bath ($50°$ C) for 4 hours, the change of weight and volume of the test piece were rapidly measured. The results are shown in Table 20.

Evaluation in Table 20 is as follows:

⊚: Increased weight or volume being 0 to 1 %

○: Increased weight or volume being 1 to 3 %

△: Increased weight or volume being 3 to 5 %

×: Increased weight or volume being 5 % or more.

Table 20

| Solvent | Solubility of Waxes | | | | Influences to Substrates | | | |
|---|---|---|---|---|---|---|---|---|
| | Melting point of Waxes | | | | Vinlychloride resin | ABS resin | Polypropylene | Acrylic resin |
| | $52°$ C | $57°$ C | $60°$ C | $65°$ C | | | | |
| Ex. 8 | ⊚ | ⊚ | ○ | △ | ⊚ | ⊚ | ○ | ⊚ |
| Ex. 9 | ⊚ | ⊚ | ○ | △ | ⊚ | ⊚ | ○ | ⊚ |
| Ex. 10 | ⊚ | ⊚ | ○ | △ | ⊚ | ⊚ | ○ | ⊚ |
| Flon-113 | ○ | △ | × | × | ⊚ | ⊚ | ⊚ | ⊚ |
| Hydrocarbons in Ex. 8 | ⊚ | ⊚ | ○ | △ | ○ | △ | △ | △ |
| Flon-113/methanol (94/6) | ○ | △ | × | × | ⊚ | ○ | ○ | × |
| Flon-113/ethanol (96/4) | ○ | △ | × | × | ⊚ | ⊚ | ⊚ | △ |
| Flon-113/isopropenol (97/3) | ○ | △ | × | × | ⊚ | ⊚ | ⊚ | △ |

The azeotropic like solvent compositions of the present invention can remarkably improve the solubility power of Flon-113 to waxes and fluxes, by admixing with the hydrocarbon mixtures and alcohols, and are excellent in controlling of the liquid composition, in collection of the used compositions and in recycle use, because of their incombustibility and a relatively stable composition. According to the solvent composition, kind of materials to be cleaned can be widened because they do not erode rubbers and plastics, and the amount of Flon-113 which may destroy the ozone layer can be reduced.

**Claims**

1. Solvent compositions comprising a major amount of 1,1,2-trichloro-1,2,2-trifluoroethane, 2 to 15 % by weight of hydrocarbons and 1 to 8 % by weight of alcohols, and the solvent compositions are incombustible and azeotropic like compositions.

2. The compositions of Claim 1, wherein the hydrocarbons have a boiling point of 49° to 62° C.

3. The compositions of Claim 1, wherein the hydrocarbons are mixtures of hydrocarbons.

4. The compositions of Claim 1, wherein the alcohols are a member selected from the group consisting of methyl alcohol, ethyl alcohol, n-propyl alcohol, iso-propyl alcohol, tert-butyl alcohol and a mixture thereof.

5. The compositions of Claim 1, wherein the compositions contain nitromethane.

EP 0 334 384 A1

# FIG. 1

Condensation                                    Condensation

Water
separator

Evaporation            Overflow          Overflow

Overflow

Dipping tank(I)

Heater

Dipping tank(II)

Vapor tank

## DOCUMENTS CONSIDERED TO BE RELEVANT

EP 89105324.1

| Category | Citation of document with indication, where appropriate, of relevant passages | Relevant to claim | CLASSIFICATION OF THE APPLICATION (Int. Cl.4) |
|---|---|---|---|
| X | EP - A2 - 0 217 181 (ALLIED CORPORATION) * Claims 1-3,8,10,12,13; page 7, lines 3-18; page 10, line 34 - page 11, line 7 * | 1-5 | C 23 G 5/028 C 11 D 7/30 /H 05 K 3/26 |
| X | EP - A1 - 0 183 109 (ALLIED CORPORATION) * Claims 1,2,4,5,7,8; page 8, lines 13-23 * | 1-5 | |
| A | GB - A - 2 038 865 (IMPERIAL CHEMICAL INDUSTRIES LIMITED) * Totality * | 1-5 | |

|  |
|---|
| TECHNICAL FIELDS SEARCHED (Int. Cl.4) |
| C 23 G C 11 D H 05 K |

The present search report has been drawn up for all claims

| Place of search | Date of completion of the search | Examiner |
|---|---|---|
| VIENNA | 01-06-1989 | HAUSWIRTH |